**Europäisches Patentamt**

**European Patent Office**

**Office européen des brevets**

(19)

(11) Veröffentlichungsnummer: **0 024 011**
**B1**

(12) **EUROPÄISCHE PATENTSCHRIFT**

(45) Veröffentlichungstag der Patentschrift:
**31.08.83**

(51) Int. Cl.³: **H 03 H 19/00**

(21) Anmeldenummer: **80104486.8**

(22) Anmeldetag: **29.07.80**

(54) Elektrische Filterschaltung unter Verwendung von wenigstens einer simulierten Induktivität, die gesteuerte Schalter, Kondensatoren und Verstärker enthält.

(30) Priorität: 09.08.79 DE 2932419
21.01.80 DE 3002056

(43) Veröffentlichungstag der Anmeldung:
18.02.81 Patentblatt 81/7

(45) Bekanntmachung des Hinweises auf die Patenterteilung:
31.08.83 Patentblatt 83/35

(84) Benannte Vertragsstaaten:
AT BE CH FR GB IT LI LU NL SE

(56) Entgegenhaltungen:

ELECTRONIC LETTERS, Band 15, Nr. 16, 2. August 1979, London, GB, U.W. BRUGGER et al.: «Switched-capacitor simulation of floating inductors using gyrators», Seiten 494-496
ELECTRONICS LETTERS, Band 14, Nr. 24, 23. November 1978, London, GB, B.J. HOSTICKA et al.: «Switched-capacitor simulation of grounded inductors and gyrators», Seiten 788-790
ELECTRONICS LETTERS, Band 15, Nr. 3, 1. Februar 1979, London, GB, G.C. TEMES et al.: «Switched-capacitor circuits bilineraly equivalent to floating inductor or F.D.N.R.», Seiten 87-88

(73) Patentinhaber: **SIEMENS AKTIENGESELLSCHAFT,**
**Berlin und München Wittelsbacherplatz 2,**
**D-8000 München 2 (DE)**

(72) Erfinder: **Nossek, Josef, Dipl.-Ing., Noestrasse 30,**
**D-8000 München 71 (DE)**

### Elektrische Filterschaltung unter Verwendung von wenigstens einer simulierten Induktivität, die gesteuerte Schalter, Kondensatoren und Verstärker enthält

Die Erfindung betrifft eine elektrische Filterschaltung unter Verwendung von wenigstens einer simulierten Induktivität, die nach vorgegebenen Taktphasen gesteuerte Schalter, Kondensatoren und Verstärker enthält und bei der ein Operationsverstärker vorgesehen ist, zwischen dessen Ausgang und invertierendem Eingang ein Kondensator geschaltet ist und dessen nicht invertierender Eingang an einem festen Bezugspotential, insbesondere Massepotential liegt, bei der weiterhin vom invertierenden Eingang des Operationsverstärkers ein Schalter zu einem ersten Schaltungsknoten führt, von dem aus ein Kondensator zu einem zweiten Schaltungsknoten führt.

Schalterfilter der vorgenannten Art sind für sich bereits durch den Aufsatz «Switched-Capacitor Filter Design Using the Bilinear z-Transform» in der Zeitschrift «IEEE Transactions on Circuits and Systems», Vol. Cas-25, Nr. 12, Dez. 1978, Seiten 1039 bis 1044 und auch durch die Arbeit «Switched-Capacitor Circuits Bilinearly Equivalent to Floating Inductor or F.D.N.R.» in der Zeitschrift Electronics Letters, 1. Febr. 1979, Vol. 15, Nr. 3, Seiten 87 und 88, bekannt geworden. Es handelt sich dabei um solche Filter, die nicht zeitkontinuierliche Analogsignale im eigentlichen Sinne verarbeiten, sondern zeitdiskrete Signale, die in Form von Abtastproben vorliegen, wobei die Abtastproben im Rhythmus einer Taktfrequenz F erzeugt werden und über die Beziehung T = 1/F wird dementsprechend T die Taktperiode genannt. Schaltungen zur Erzeugung solcher Abtastproben sind für sich bekannt, so dass sie an dieser Stelle nicht im einzelnen erläutert werden müssen. Es ist jedoch auch im folgenden davon auszugehen, dass den dargestellten Schaltungen solche Abtastschaltungen jeweils vor- bzw. nachgeschaltet sein können, so dass es also einerseits gelingt, aus einem Analogsignal entnommene Abtastproben der Filterschaltung eingangsseitig zuzuführen und die ausgangsseitig zur Verfügung stehenden Signale wieder in zeitkontinuierliche Analogsignale umzuwandeln. Der wesentliche technische Vorteil solcher Filter ist darin zu sehen, dass Spulen durch aktive Schaltelemente und Kondensatoren nachgebildet werden, so dass sie sich zur monolithischen Integration von grösseren Filterschaltungen eignen. Als Verstärker werden dabei überwiegend die bekannten Operationsverstärker eingesetzt und es wird dabei angestrebt, einerseits eine möglichst geringe Anzahl von Schaltelementen anwenden zu müssen und andererseits auch die Stabilität solcher Schaltungen zu gewährleisten. Bei den vorerwähnten bekannten Schaltungen wird ebenfalls der invertierende Eingang mit dem Ausgang eines Operationsverstärkers über einen Kondensator verbunden, also gewissermassen gegengekoppelt. Jedoch zeigt sich dass die zum Einsatz kommenden Operationsverstärker zeitweilig nicht gegengekoppelt sind bzw. eine hohe Gleichtaktunterdrückung benötigen, da der nicht invertierende Eingang des Operationsverstärkers während gewisser Schaltphasen kurzzeitig nicht gegengekoppelt ist bzw. nicht stets auf Massepotential gehalten wird. Weiterhin erfolgt die Realisierung der Kondensatoren in der Art der MOS-Technologie (Metalloxydsilizium-Technologie) und es zeigt sich, dass bei diesen Realisierungsverfahren die unvermeidlichen mit jedem schwebenden MOS-Kondensator verbundenen Erdkapazitäten zu erheblichen Störungen der Filterfunktion führen können.

In der Zeitschrift «Electronics Letters», Bd. 15, Nr. 16 vom 2. August 1979, Seiten 494 bis 496 ist eine Schaltung angegeben, bei der mit Hilfe von geschalteten Kapazitäten sowohl schwebende als auch einseitig geerdete Spulen nachgebildet werden. Auch bei dieser bekannten Schaltung wird ein Operationsverstärker verwendet, von dessem Ausgang ein Kondensator auf den nichtinvertierenden Eingang zurückgeführt ist. Weiterhin werden zwei Schalterarten verwendet, die zu zwei verschiedenen Taktzeitpunkten schalten. Wie bereits in der Überschrift dieses Aufsatzes ausgesagt ist, werden dort Gyratorschaltungen zur Realisierung der Spulen herangezogen.

Aus «Electronics Letters», Vol. 14, No. 24, Seiten 788 bis 789 ist eine Schaltung bekannt, die nach vorgegebenen Taktphasen gesteuerte Schalter, Kondensatoren und Verstärker enthält und bei der ein Operationsverstärker vorgesehen ist, zwischen dessen Ausgang und invertierendem Eingang ein Kondensator geschaltet ist und dessen nicht invertierender Eingang an einem festen Bezugspotential, insbesondere Massepotential liegt, bei der weiterhin vom invertierenden Eingang des Operationsverstärkers ein Schalter zu einem ersten Schaltungsknoten führt, von dem aus ein Kondensator an Massepotential liegt und ein weiterer Schalter zu einem zweiten Schaltungsknoten führt.

Diese bekannte Schaltung ist aber verhältnismässig einfach und nicht zur Ausbildung von schwebenden Spulen geeignet. Insgesamt beruhen zudem die beiden vorgenannten Schaltungen nicht auf der bilinearen z-Transformation, so dass sie Einschränkungen bei der Wahl von Taktfrequenz zu Signalfrequenz unterworfen sind.

Der Erfindung liegt die Aufgabe zugrunde, Schaltungen zur Nachbildung von aktiv realisierbaren Spulen unter Verwendung einer bilinearen Transformation anzugeben, die sowohl als schwebende als auch als einseitig geerdete Spulen in sogenannten Switched-Capacitor-Filtern eingesetzt werden können und bei denen die durch Schaltvorgänge auftretenden Störungen nach Möglichkeit vermieden sind und man möglichst keinen Einschränkungen bei der Wahl von Taktfrequenz zu Signalfrequenz unterworfen ist. Ausgehend von den einleitend genannten Filterschaltungen wird diese Aufgabe erfindungsgemäss durch die im kennzeichnenden Teil des Patentanspruch 1 dargelegten Merkmale gelöst.

Weitere vorteilhafte Ausgestaltungen sind in den Unteransprüchen angegeben.

Anhand von Ausführungsbeispielen wird nachstehend die Erfindung noch näher erläutert.

Es zeigen in der Zeichnung

Fig. 1 die Realisierung einer einseitig geerdeten Induktivität,

Fig. 2 das Taktschema zur Betätigung der einzelnen Schalter in den Taktphasen 1 bis 6' mit der Taktperiode T; das Taktschema hat dabei auch für die folgenden Schaltungen Gültigkeit,

Fig. 3 das zur Schaltung von Fig. 1 gehörige elektrische Ersatzschaltbild unter Berücksichtigung der komplexen Frequenz s bzw. unter Berücksichtigung der an sich bekannten $\Psi$-Transformation,

Fig. 4 eine Schaltung zur Realisierung einer schwebenden Induktivität, d.h. also einer nicht auf Massepotential liegenden Induktivität,

Fig. 5 das elektrische Ersatzschaltbild für die Schaltung nach Fig. 4 mit analogen Bezeichnungen zu Fig. 3,

Fig. 6 eine Schaltung zur Realisierung einer geerdeten Induktivität mit reduzierter Aussteuerung des Operationsverstärkers,

Fig. 7 einen elektrischen Zweipol in Form einer Kapazität C, die die Erdkapazität C' hat,

Fig. 8 einen elektrischen Zweipol zur Nachbildung eines ohmschen Widerstandes, bei dem die Erdkapazitäten $\frac{C'}{2}$ auftreten,

Fig. 9 die Schaltung für einen Schalterkondensator-Hochpass, der an einer Spannungsquelle $U_0$ mit dem getakteten Innenwiderstand $C_0$ und dem getakteten Lastwiderstand $C_L$ betrieben wird; am Lastwiderstand $C_L$ liegt dabei die Ausgangsspannung $U_L$,

Fig. 10 das elektrische Ersatzschaltbild der in Fig. 9 gezeigten Schaltung unter Berücksichtigung der Erdkapazitäten,

Fig. 11 die Realisierung zweier schwebender Parallelresonanzkreise mit Kompensation der parasitären Erdkapazitäten,

Fig. 12 eine Schaltung zur Herausführung des reflektierten Signals durch die nach Art einer Weichenschaltung ein Übertragungsverhalten erreicht werden kann, das invers ist zum Übertragungsverhalten des in der Schaltung angeschlossenen Filters.

Fig. 13 das elektrische Ersatzschaltbild des zu realisierenden Parallelresonanzkreises mit der Induktivität $L = \frac{T^2}{4C_L}$ und der Kapazität C,

Fig. 14 eine weitere, den Parallelresonanzkreis von Fig. 13 realisierende, aktive Schaltung.

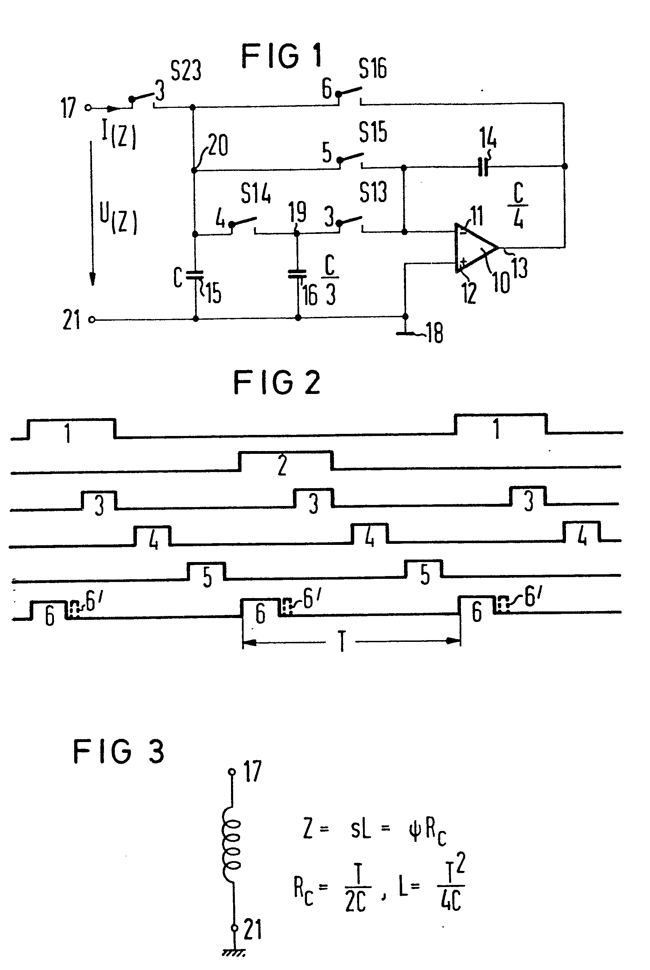

Im Ausführungsbeispiel von Fig. 1 ist zu erkennen ein Operationsverstärker 10, dessen nicht invertierender Eingang 12 auf Bezugspotential, im vorliegenden Fall auf Massepotential 18, geschaltet ist. Der Ausgang des Operationsverstärkers ist mit 13 bezeichnet, sein invertierender Eingang mit 11, und zwischen Ausgang 13 und invertierendem Eingang 11 liegt der Kondensator 14, von dem als bevorzugte Ausbildungsform angenommen sei, dass er den Kapazitätswert $\frac{C}{4}$ hat. Im Zuge der Schaltung sind weiter zu erkennen die Schalter S13, S14, S15, S16 und S23, von denen der Schalter S13 auf einen Schaltungsknoten 19 und die Schalter S15 und S16 auf einen Schaltungsknoten 20 führen. Der Schaltungsknoten 19 und der Schaltungsknoten 20 stehen über den Schalter S14 in Verbindung und es liegt weiterhin zwischen dem Schaltungsknoten 19 und Massepotential 18 ein Kondensator 16, während zwischen dem Schaltungsknoten 19 und Bezugspotential 18 ein Kondensator 15 liegt. Das dargestellte bevorzugte Ausführungsbeispiel, nämlich die Nachbildung einer verlustfreien Spule ergibt sich dann, wenn bei einem Kapazitätswert $\frac{C}{4}$ des Kondensators 14 der Kapazitätswert des Kondensators 16 $\frac{C}{3}$ beträgt, wobei davon ausgegangen ist, dass der Kondensator 15 den Kapazitätswert C hat. Der Schaltungsknoten 20 ist über den Schalter S23 mit einer der oberen Eingangsklemmen 17 verbunden. Die untere Eingangsklemme ist mit 21 bezeichnet. Im vorliegenden Fall liegt also auch die Eingangsklemme 21 auf Bezugspotential 18. Wenn zwischen den Klemmen 17 und 21 die Spannung $U_{(Z)}$ anliegt, dann fliesst in die Schaltung der Strom $I_{(Z)}$.

Die Bezeichnung der Schalter ist in Fig. 1 und auch für die weiteren Figuren so gewählt, dass die Schalter S in Verbindung mit einer zweistelligen Zahl bezeichnet sind, deren zweite Ziffer übereinstimmt mit den Taktphasen, in denen diese Schalter geschlossen sein müssen.

Die einzelnen Taktphasen sind in Fig. 2 dargestellt, wobei davon auszugehen ist, dass die Zeiten, in denen die einzelnen Schalter geschlossen sind, durch den Zeitabschnitt kenntlich gemacht sind, der über die Bezugslinie hinausragt. Auch ist davon auszugehen, dass einzelne Taktphasen sich nicht überschneiden, wie dies beispielsweise in den Taktphasen 3, 4, 5 und 6 zu erkennen ist, bei denen Schalter mit beispielsweise der Taktphase 4 erst geschlossen werden dürfen, wenn mit der Taktphase 3 betriebene Schalter bereits geöffnet sind. Entsprechend gilt dies auch für die übrigen Schalter. In Fig. 2 ist auch die eingangs bereits definierte Taktperiode T zu erkennen.

Betrachtet man unter diesen Voraussetzungen die in Fig. 1 gezeigte Schaltung, dann ist zu erkennen, dass die Schalter S13 und S23 während der Taktphase 3, der Schalter S14 während der Taktphase 4, der Schalter S15 während der Taktphase 5 und der Schalter S16 während der Taktphase 6 geschlossen sein muss.

Bei der in Fig. 1 dargestellten Realisierung einer geerdeten Induktivität haben die Erdkapazitäten überhaupt keinen Einfluss, da die benötigten MOS-Kondensatoren entweder geerdet oder mit einer Elektrode an einen niederohmigen Operationsverstärkerausgang angeschaltet sind. Weiterhin liegt der nicht invertierende Eingang 11 des Operationsverstärkers stets auf Massepotential und er ist ausserdem stets durch den Kondensator 14 gegengekoppelt.

Im elektrischen Ersatzschaltbild von Fig. 3 ist unmittelbar die Wirkung der Schaltung nach Fig. 1 zwischen den Klemmen 17 und 21 zu erkennen. Die Impedanz Z der Schaltung bestimmt sich dabei nach der Form $Z = s \cdot L = \Psi \cdot R$, wobei weiterhin gilt $R_c = \frac{T}{2C}$, $L = \frac{T^2}{4C}$. Mit $s = \mathcal{E} + J\Omega$ ist weiterhin die komplexe Frequenzvariable des Referenzfilters definiert und durch die Grösse $\Psi = \frac{1}{2} \cdot s$ wird die soge-

nannte $\Psi$-Transformation berücksichtigt, deren theoretischer Inhalt an sich bekannt ist und die auch im folgenden im Zusammenhang mit der Erfindung noch erläutert wird. $R_C$ ist der sogenannte Sprungwiderstand, für den sich in der englischen Fachsprache auch der Ausdruck «step resistance» eingebürgert hat.

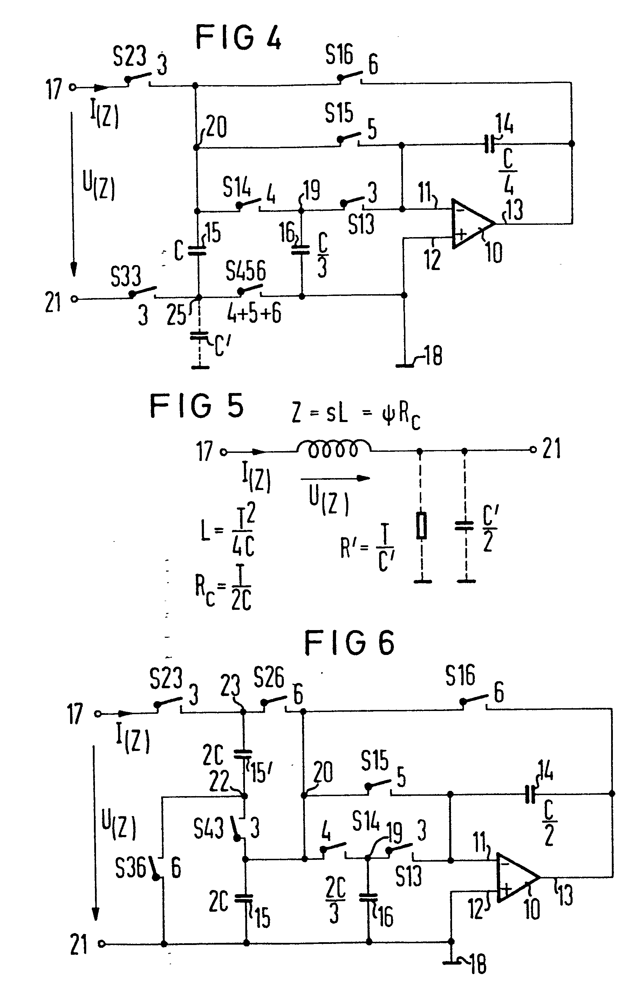

Dieser letztgenannte Vorteil bleibt auch im Ausführungsbeispiel von Fig. 4 vollständig erhalten, in der die Realisierung einer schwebenden Induktivität, also einer nicht einseitig auf Bezugspotential liegenden Induktivität, dargestellt ist. Es tritt dabei jedoch eine Impedanz von einer Spulenklemme zur Erde hinzu, die jedoch in viele Fällen durch eine geschickte Anordnung der Gesamtschaltung oder auf jeden Fall durch den Einsatz eines zusätzlichen Verstärkers wieder eliminiert werden kann.

Im Ausführungsbeispiel von Fig. 4 und der zugehörigen Ersatzschaltung in Fig. 5 ist die Realisierung einer schwebenden Induktivität gezeigt. Wie im Zusammenhang mit Fig. 1 bereits erwähnt, sind auch hier die einzelnen Schalter unmittelbar mit den Taktphasen zu erkennen, so dass diesbezüglich auch die für Fig. 1 bereits gegebenen Erläuterungen Gültigkeit haben.

Abweichend von Fig. 1 ist in der Schaltung nach Fig. 4, dass zwischen der Eingangsklemme 21 ein weiterer Schaltungsknoten 25 erreicht wird. Vom Schaltungsknoten 25 führt ein Schalter S456 unmittelbar zu dem auf Massepotential liegenden nicht invertierenden Eingang 12 des Operationsverstärkers 10. Der Schalter S33 wird ebenso wie der Schalter S23 während der Taktphase 3 geschlossen, während der Schalter S456 während der Taktphasen 4, 5 und 6 geschlossen ist. Zwischen dem Schaltungsknoten 25 und Massepotential bildet sich eine parasitäre Schaltkapazität aus, die gestrichelt eingezeichnet ist und deren Kapazitätswert mit C' bezeichnet ist. Für das elektrische Ersatzschaltbild von Fig. 5 gelten analog die zu Fig. 3 bereits gegebenen Erläuterungen und es sind auch dort die sich ergebenden formelmässigen Beziehungen unmittelbar an die einzelnen Schaltelemente angeschrieben. Dementsprechend erscheint zwischen den Klemmen 17 und 21 eine schwebende Induktivität und es bildet sich zwischen der Klemme 21 und Bezugspotential ein Ableitwiderstand $R' = \dfrac{T}{C'}$, und dazu parallel eine parasitäre Kapazität mit dem Wert $\dfrac{C'}{2}$ aus.

Im Ausführungsbeispiel von Fig. 6 ist die Realisierung einer geerdeten Induktivität gemäss Fig. 1 mit reduzierter Aussteuerung des Operationsverstärkers gezeigt. Schaltungen dieser Art lassen sich entsprechend auch bei der Realisierung schwebender Induktivitäten gemäss Fig. 4 aufbauen. Ein Vergleich der Figuren 1 und 6 lässt erkennen, dass die dort gezeigten Schaltungen in wesentlichen Teilen übereinstimmen. Gegenüber Fig. 1 wird beim Ausführungsbeispiel nach Fig. 6 nach dem Schalter S23 ein weiterer Schaltungsknoten 23 eingeführt, der einerseits auf den in der Taktphase 6 zu schliessenden Schalter S26 und andererseits an den Kondensator 15' führt.

Dem Kondensator 15' im Querzweig folgt ein weiterer Schaltungsknoten 22, von dem aus der Schalter S36 unmittelbar auf Bezugspotential 18, im Beispiel also an die Eingangsklemme 21 führt. Am Schaltungsknoten 22 liegt ein weiterer Schalter S43, der wiederum auf den Kondensator 15 führt. Analog zu den vorstehenden Ausführungen ist auch zu erkennen, dass die gegenüber Fig. 1 in Fig. 6 neu hinzugekommenen Schalter S26 und S36 während der Taktphase 6 geschlossen sind, während der Schalter S43 gleichzeitig mit den Schaltern S23 und S13 während der Taktphase 3 geschlossen ist. Die Kapazitätsverhältnisse bleiben für die verlustfreie Schaltung vollständig erhalten, jedoch sind lediglich die Kapazitätswerte zur besseren Übersicht mit dem Faktor 2 behaftet dargestellt.

Die physikalische Wirkungsweise und die Vorteile, die sich mit solchen Schaltungen erzielen lassen, werden später noch erläutert.

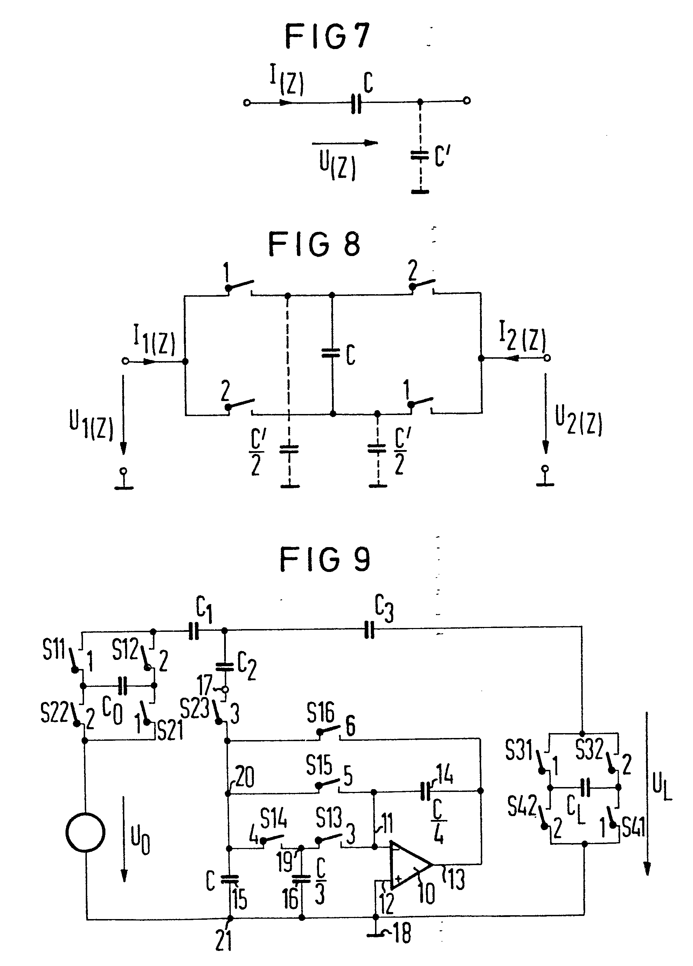

Zum besseren Verständnis wird im folgenden anhand der Figuren 7 und 8 die physikalische Wirkungsweise für die in den Schaltungen verwendeten Teilschaltungen erläutert.

Da es sich bei SC-Filtern (Switched-Capacitor-Filter) um analoge Abtastsysteme handelt, die, wie schon erwähnt, Abtastfolgen verarbeiten, müssen Ersatzströme und Ersatzspannungen definiert werden, die nach Anwendung der bilinearen Transformation auf realisierbare, rational gebrochene Zweipol- bzw. Übertragungsfunktionen führen. Da die Signale im allgemeinen in Form von Spannungswerten in das SC-Filter eingegeben bzw. entnommen werden, ist es besonders wichtig, eine realitätsbezogene Spannungsdefinition zu wählen, damit bei der Signalein- bzw. -auskopplung keine Kunstschaltungen benötigt werden.

Die Spannungen an den Kondensatoren eines Schalter-Kondensator-Netzwerks springen beim vom Taktzeitplan kontrollierten Fliessen von Ladungspaketen von einem Vorherwert $u_b(nT) = U_b \cdot e^{pnT}$ auf einen Nachherwert $u_a(nT) = U_a \cdot e^{pnT}$. Als Ersatzspannung, mit der wir von nun an rechnen, wird

$$U(z) = U_a(z) \qquad (1)$$

definiert. Diese Festlegung ermöglicht nicht nur die einfachste Signalein- bzw. -auskopplung, sondern erleichtert auch die Zusammenschaltung der im folgenden noch zu behandelnden Netzwerkelemente zu einem SC-Filter.

Aus der Ladungsdefinition

$$q(nT) = \int_{\frac{2n-1}{2}T}^{\frac{2n+1}{2}T} i(t)\, dt \qquad (2)$$

folgt die Stromdefinition

$$I(z) = \frac{2}{T} \cdot \frac{z}{z+1} \cdot Q(z). \qquad (3)$$

Diese Ladungs- und Stromdefinitionen sind so gewählt, dass sich mit der neuen Frequenzvariablen s

$$s = \varepsilon + j\Omega = \frac{2}{T} \phi$$

$$\phi = \frac{z-1}{z+1} = \tanh \frac{pT}{2} = \varepsilon + j\varphi \qquad (4)$$

$$p = \sigma + j\omega$$

für das am häufigsten auftretende Zweipolelement spulensparsamer LC-Filter, den Kondensator, die einfachste Realisierung im SC-Filter ergibt.

Im folgenden werden unter Anwendung der Spannungs- und Stromfestlegungen (1) und (3) die Zweipole Kapazität, Widerstand und Induktivität realisiert und die Einflüsse der parasitären Kapazitäten bzw. des nicht idealen Operationsverstärkers untersucht.

Wie bereits vorstehend erwähnt, ergeben für die in Fig. 7 gezeigte Kapazität die Definitionen (1) und (3) eine besonders einfache Realisierung der Impedanz $Z(s) = 1/sC$.

Es gilt:

$$Q(z) = C(U_a - U_b).$$

Mit $U_a = U, U_b = Uz^{-1}$

folgt $Q(z) = C \cdot U(z) (1 - z^{-1})$

und $I(z) = \frac{2C}{T} \cdot \frac{z-1}{z+1} \cdot U(z). \qquad (5)$

Der Index «a» (after) bedeutet dabei den Zustand nach dem Schalten und entsprechend der Index «b» (before) den Zustand vor dem Schalten.

Damit wird

$$Z = \frac{U}{I} = \frac{T}{2C} \frac{z+1}{z-1} = \frac{R_c}{\psi} = \frac{1}{sC} \quad . \qquad (6)$$

$$\begin{bmatrix} I_1(z) \\ I_2(z) \end{bmatrix} = \begin{bmatrix} \frac{2}{T}(\frac{z-1}{z+1} \cdot \frac{C'}{4} + C + \frac{C'}{4}), & \frac{2}{T}(\frac{z-1}{z+1} \cdot \frac{C'}{4} - C - \frac{C'}{4}), \\ \frac{2}{T}(\frac{z-1}{z+1} \cdot \frac{C'}{4} - C - \frac{C'}{4}), & \frac{2}{T}(\frac{z-1}{z+1} \cdot \frac{C'}{4} + C + \frac{C'}{4}), \end{bmatrix} \cdot \begin{bmatrix} U_1(z) \\ U_2(z) \end{bmatrix} \qquad (8)$$

Aus dieser Leitwertmatrix lässt sich eine Ersatzschaltung ableiten, die aus einem Kreuzglied mit dem halben Sprungwiderstand (R/2) in den Linienzweigen und der Kapazität C'/2 in den Diagonalzweigen besteht. Äquivalent zu diesem Kreuzglied-Ersatzschaltbild ist bekanntlich ein überbrücktes T-Glied, das ebenfalls für Schaltungsentwürfe verwendet werden kann.

Dieser, durch die parasitären Erdkapazitäten hervorgerufene, nicht minimalphasige Charakter des Netzwerks beeinflusst das SC-Filter praktisch nicht, da er nur in den Abschlüssen auftritt.

Im Gegensatz zu den eingangs genannten Literaturstellen soll hier nicht zur Realisierung eines induktiven Scheinwiderstandes eine RC-aktive Realisierung mit den vorstehend besprochenen Zweipolrealisierungen und den einleitend genannten Nachteilen nachgebildet werden. Es wird vielmehr nach einer di-

$R_c$ ist der Sprungwiderstand der Kapazität.

Die den schwebenden Kondensator C begleitende Erdkapazität C' kann bereits beim Entwurf des zeitinvarianten Referenzfilters eingerechnet werden.

In Fig. 8 ist eine Schaltung zur Nachbildung eines Widerstandes gezeigt. Gemäss den einleitend genannten Literaturstellen lässt sich eine konstante reelle Impedanz durch einen periodisch umgepolten Kondensator realisieren. Dies erfolgt am Kondensator C durch die während der Taktphasen 1 bzw. 2 geschlossenen Schalter.

Ohne Berücksichtigung der Erdkapazitäten gilt zunächst

$$U(z) = U_1(z) - U_2(z)$$

und $I(z) = I_1(z) = -I_2(z),$

sowie $U_b = -U_a z^{-1}.$

Damit folgt $Q(z) = C(U_a - U_b) = CU(1 + z^{-1})$

und weiter $I(z) = \frac{2C}{T} \cdot U(z)$

$$\qquad (7)$$

$$Z = \frac{U}{I} = \frac{T}{2C} = R_c.$$

Es ist hier besonders wichtig, die den schwebenden MOS-Kondensator begleitende Erdkapazität gemäss Fig. 2 symmetrisch anzuordnen. Würde diese parasitäre Kapazität nicht symmetrisch aufgeteilt, so wiederholte sich die Topologie des Netzwerks nur mehr alle 2T Sekunden. Dies wiederum hätte die Erzeugung von zusätzlichen Spiegelfrequenzen $\frac{(n+1)}{2}$ $\Omega + \omega$ und damit verschärfte Forderungen an die zeit-invarianten Vor- bzw. Nachfilter zur Folge. Es wird deshalb im folgenden immer von symmetrisch aufgeteilten Erdkapazitäten eines periodisch umgepolten MOS-Kondensators ausgegangen.

Unter dieser Voraussetzung ergibt sich für die Anordnung in Fig. 8 die folgende Beziehung

rekten Realisierung der Differenzengleichungen gesucht, die sich für den Zweipol «Induktivitäten» (vgl. Fig. 1 bis Fig. 6) ergeben.

$$Z = \frac{U(z)}{I(z)} = \frac{2}{T} \cdot \frac{z-1}{z+1} \cdot L = \frac{z-1}{z+1} \cdot \frac{T}{2C} \quad . \qquad (9)$$

Aus (9) ergibt sich mit den Definitionen (1) - (3)

$$U(z) \cdot C = \frac{T}{2} \cdot \frac{z-1}{z+1} \cdot \frac{2}{T} \cdot \frac{z}{z+1} \cdot Q(z) = \frac{1-z^{-1}}{(1+z^{-1})^2} \cdot Q(z).$$

Weiters gilt

$$Q(z) = C[U_a(z) - U_b(z)] = CU(z)[1 - \frac{U_b}{U_a}(z)]. (10)$$

Durch Vergleich von (9) und (10) erhält man

$$\frac{U_b}{U_a}(z) = -\frac{z^{-2} + 3z^{-1}}{1 - z^{-1}}, \qquad (11)$$

D.h. es wird eine Schaltung gesucht, die die Übertragungsfunktion (11) realisiert und die von dem die Induktivität realisierenden Kondensator ihr Eingangssignal $U_a$ bezieht und noch vor Eintreffen des nächsten Ladungspaketes diesem die Ausgangsspannung $U_b$ aufzwingt. Aufgrund des Nennerpolynoms $N(z) = 1 - z^{-1}$ in (11) erkennt man, dass die diese Übertragungsfunktion realisierende Anordnung Integratorcharakter haben muss. Die unterschiedlichen Gewichtsfaktoren für die Vorwärtsverzögerungen können durch Ladungsverteilung bei entsprechend gewähltem C-Verhältnis realisiert werden.

Aus der Übertragungsfunktion (11), die bei der Realisierung einer Induktivität verwirklicht wird, kann man erkennen, dass die Spannung am Operationsverstärkerausgang $U_b$ die Signalspannung an der Induktivität $U = U_a$ übersteigen kann.

Eine Möglichkeit zur Herabsetzung von $U_b$ um den Faktor zwei ist in der im wesentlichen bereits erläuterten Fig. 6 angegeben.

Die in der Schaltung in Fig. 6 auftretenden Erdkapazitäten können voll berücksichtigt werden. Bei Realisierung einer schwebenden Spule mit reduzierter Aussteuerung ist die Auswirkung der Erdkapazitäten nicht ohne weiteres zu beseitigen. Ein zusätzlicher Verstärker kann jedoch für zwei benachbarte schwebende Spulen gleichzeitig Abhilfe schaffen.

Die Spannung am Ausgang des Operationsverstärkers $U_b$ folgt ebenso wie die Spulenspannung $U_a$ der Signalspannung. D.h. die Sprünge im treppenförmigen Verlauf werden umso kleiner, je kleiner die Signalfrequenz relativ zur Taktfrequenz ist. Es muss zwar die Kapazität C (Fig. 4) fallweise erheblich umgeladen werden, jedoch braucht bei diesen Umladevorgängen nicht der ganze Operationsverstärker über alle Stufen hinweg einzuschwingen.

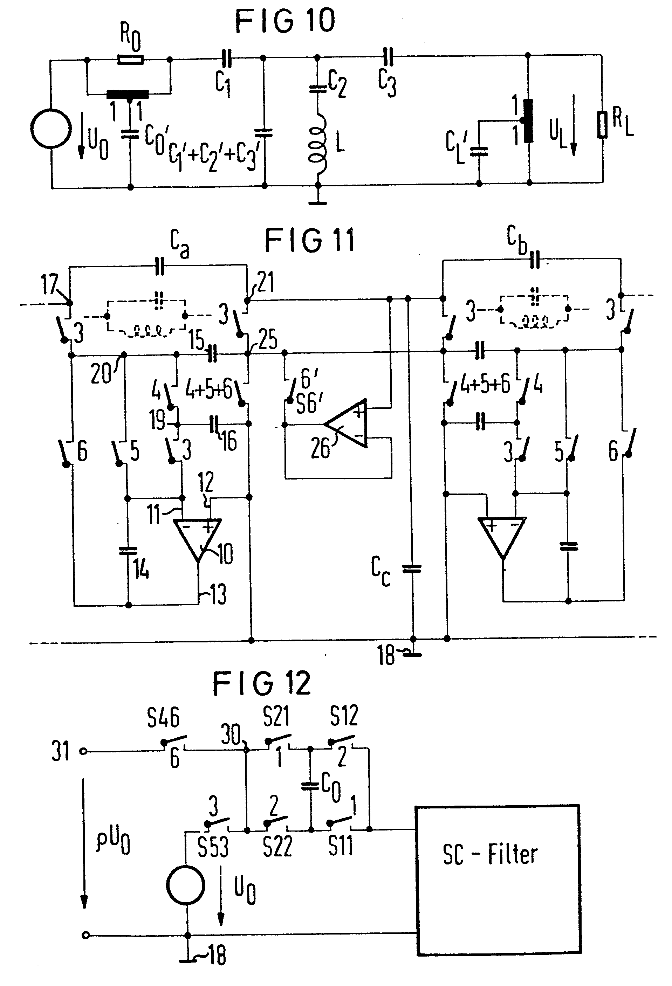

In den Figuren 9 und 10 ist als Realisierungsbeispiel für eine Filterschaltung eine Hochpassschaltung vom Grad 3 gezeigt, die in ihren Längszweigen die Kondensatoren $C_1$ und $C_2$ enthält und in dem dazwischenliegenden Querzweig einen Serienresonanzkreis aus den Kondensatoren $C_2$ und Spule L. Als Schaltkapazitäten treten zusätzlich die zu den Kondensatoren $C_1$ bis $C_3$ gehörenden Erdkapazitäten auf die als Summenkapazität $C_1' + C_2' + {}_3'$ parallel zum Serienresonanzkreis $C_2$, L liegen. Die Spannungsquelle $U_0$ mit dem Innenwiderstand $R_0$ und der Lastwiderstand $R_L$, an dem die Ausgangsspannung $U_L$ auftritt, sind in den Figuren 9 und 10 ebenfalls zu erkennen und es sind auch deren Erdkapazitäten $C_0'$ bzw. $C_L'$ über einen parallel zu den Widerständen $R_0$ bzw. $R_L$ liegenden Übertrager mit dem Übersetzungsverhältnis 1 : 1 berücksichtigt. Ein Vergleich der Figuren 1, 7 und 8 mit Fig. 10 lässt unmittelbar erkennen, dass in die Schaltung von Fig. 9 die anhand der vorstehend genannten Figuren erläuterten Schaltelemente eingeführt sind. Es wird also zwischen den Klemmen 17 und 21 vollständig die Spule gemäss Fig. 1 nachgebildet. Die zur Hochpassschaltung gehörenden kapazitiven Elemente $C_1$, $C_2$ und

$C_3$ aus der Schaltung von Fig. 10 werden auch in der realisierten Schaltung gemäss Fig. 9 unmittelbar als Kondensatoren $C_1$, $C_2$ und $C_3$ an genau den gleichen Schaltungsstellen nachgebildet. Analog ist auch der Wirkwiderstand gemäss Fig. 8 für den Widerstand $R_0$ durch den periodisch umgepolten Kondensator $C_0$ und für den Lastwiderstand $R_L$ durch den periodisch umgepolten Kondensator $C_L$ nachgebildet. Entsprechend Fig. 7 sind für die umzupolenden Schalter am Kondensator $C_0$ und am Kondensator $C_L$ die Taktphasen mit 1 und 2 bezeichnet und es sind lediglich zur Unterscheidung am Kondensator $C_0$ die Schalter mit S11 und S21 bzw. S12 und S22 bezeichnet. Entsprechend dazu sind die Schalter am Kondensator $C_L$ mit S31 und S41 bzw. S32 und S42 bezeichnet.

Die Realisierung andersartiger Filterschaltungen lässt sich in analoger Anwendung der vorstehenden Ausführungen ebenfalls erreichen, insbesondere auch durch die Anwendung von schwebenden Spulen gemäss Fig. 4, die bei der Nachbildung von Tiefpässen, Bandpässen bzw. Bandsperren angewendet werden kann.

Eine vorteilhafte Ausführungsvariante ist in Fig. 11 für Tiefpassschaltungen gezeigt und durch die gestrichelten Linien am Schaltungseingang und am Schaltungsausgang soll erkenntlich gemacht werden, dass lediglich ein Ausschnitt aus einer solchen Tiefpassschaltung dargestellt ist. Nachgebildet wird dabei eine Schaltung, in deren Querzweig ein Kondensator $C_c$ liegt und bei der zwei im Längszweig liegende Parallelresonanzkreise nachgebildet werden müssen, wie dies durch die ebenfalls gestrichelt eingezeichneten elektrischen Ersatzschaltbilder unmittelbar zu erkennen ist. Den in Längszweigen liegenden, mit $C_a$ und $C_b$ bezeichneten Kondensatoren wird dabei eine schwebende Induktivität gemäss Fig. 5 zugeschaltet, so dass unmittelbar auf die diesbezüglich gegebenen Erläuterungen zurückzugreifen ist. Zur besseren Übersicht sind die einzelnen Schalter nurmehr durch die miteingezeichneten Taktphasen kenntlich gemacht. In der Schaltung von Fig. 11 wird nun zusätzlich ein Spannungsverstärker 26 mit der Verstärkung + 1 verwendet. Dieser Spannungsverstärker ist über einen Schalter S6', der in der Taktphase 6' (vgl. Fig. 2) geschlossen ist, an einen Schaltungsknoten 25 angeschaltet, an dem auch der Kondensator 15 liegt, d.h. also derjenige Kondensator, der für die Induktivitätsnachbildung gemäss Fig. 4 den grössten Kapazitätswert aufweist. Mit Hilfe dieser Anordnung lassen sich die bei schwebenden Induktivitäten auftretenden parasitären Ableitungsadmittanzen beseitigen.

Dabei wird eine neue Taktphase 6', die zwischen den Taktphasen 6 und 3 einzufügen ist, benötigt. Dass der nichtinvertierende Eingang des zusätzlichen Operationsverstärkers nicht an Masse liegt, ist hier kein echter Nachteil, da er nicht umgeschaltet wird und seine Eingangskapazität voll eingerechnet werden kann.

In der Schaltung von Fig. 12 wird das von einem SC-Filter reflektierte Signal als Ausgangssignal der Schaltung ausgenutzt. In der gezeichneten Schaltung ist wiederum der Signalgenerator $U_0$ zu erkennen, der über einen Schalter S53, der während der Taktphase 3 geschlossen ist, an die übrige SC-Filterschaltung angeschlossen ist. Es wird dabei der den Generatorinnenwiderstand $C_0$ nachbildende, periodisch umgepolte Kondensator (vgl. Fig. 9) an einen weiteren Schaltungsknoten 30 geführt. Von diesem Schaltungsknoten führt der Schalter S46 zu einer Ausgangsklemme 31 und es kann zwischen der Klemme 31 und Bezugspotential 18 das vom SC-Filter reflektierte Signal $\varrho$ . $U_0$ ($\varrho$ = Reflexionsfaktor) abgenommen werden, wenn dafür gesorgt ist, dass der Schalter S53 während der Taktphase 3 und der Schalter S46 während der Taktphase 6 geschlossen sind. Eine solche Schaltung wirkt also als strenge Weichenschaltung.

Allgemein kann also das reflektierte Signal am Ein- und Ausgang des SC-Filters ohne merklichen Zusatzaufwand zu bestimmten Zeitpunkten abgegriffen werden. Voraussetzung ist dabei, dass vom jeweiligen Tor des Filters ein nicht geschalteter kapazitiver Pfad zur Masse besteht. Diese Bedingung wird in fast allen Fällen schon wegen der Berücksichtigung der Erdkapazitäten erfüllt sein.

Weiters kann durch gleichartige Ausgestaltung des Lastwiderstandes mit einer zweiten Signalquelle das SC-Filter in beiden Übertragungsrichtungen simultan benützt werden. Allerdings ist die Übersprechdämpfung zwischen beiden Übertragungsrichtungen identisch mit der Reflexionsdämpfung des SC-Filters.

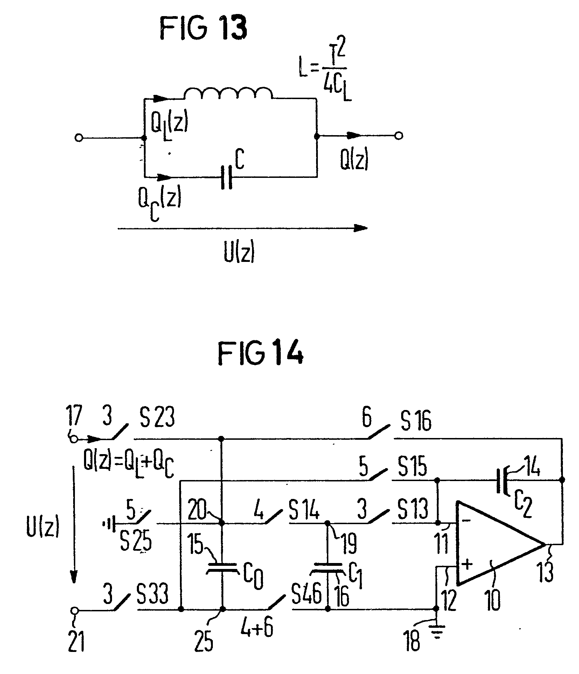

Fig. 13 lässt erkennen, dass von der Induktivität L die Ladung $Q_L(z)$ und von Kondensator C die Ladung $Q_C(z)$ aufgenommen wird, so dass insgesamt die Ladung Q(z) im schwebenden Parallelresonanzkreis transportiert wird. Der auftretende Spannungsabfall ist mit U(z) bezeichnet. Die Konstante $C_L = T^2/4L$ ist demzufolge unmittelbar aus der für den Parallelresonanzkreis zu realisierenden Induktivität L und der systemeigenen Taktperiode T zu ermitteln. Im einzelnen sind anhand der Figuren 1 bis 12 weitere Bemessungsgrössen angegeben und es ist auch hingewiesen auf die Anwendung der sogenannten z-Transformation, die bei der Berechnung von getasteten Systemen häufig verwendet wird.

Wie vorstehend bereits ausgeführt ist in 4 eine Schaltung gezeigt, die in vielen wesentlichen Teilen mit der Schaltung der hier vorliegenden Fig. 14 übereinstimmt. Zur Erläuterung von Fig. 14 kann also vollständig auf die Ausführungen zu den Figuren 1 bis 13 hingewiesen werden, in denen auch die physikalische Wirkungsweise und das für die Steuerung der Schalter erforderliche Taktschema dargestellt sind. Auch sind wirkungsgleiche Elemente mit den gleichen Bezugsziffern bezeichnet und es sind die Taktphasen, in denen die einzelnen Schalter geschlossen sind, auch in der vorliegenden Fig. 14 unmittelbar an den einzelnen Schaltern angegeben. Entsprechend Fig. 4 sind also in Fig. 14 folgende Schaltelemente unmittelbar wiederzuerkennen.

Zwischen den Eingangsklemmen 17 und 21 liegt die Eingangsspannung U(z) und es folgt diesen Klemmen der Schalter S23 bzw. der Schalter S33, die zur Taktphase 3 schliessen. Ferner ist zu erkennen ein Schaltungsknoten 20, dem ein Kondensator 15 in Richtung zum Schaltungsknoten 25 nachgeschaltet ist. Vom Schaltungsknoten 20 führt ein während der Taktphase 4 schliessender Schalter S14 auf einen weiteren Schaltungsknoten 19, von dem aus der Kondensator 16 auf Bezugspotential 18 führt. Das Integrationsglied besteht ebenfalls aus einem Operationsverstärker 10, dessen invertierender Eingang mit der Bezugsziffer 11 und dessen nicht invertierender Eingang mit der Bezugsziffer 12 bezeichnet sind und an dessen Ausgang 13 der Kondensator 14 geschaltet ist, von dem aus wiederum der invertierende Eingang 11 erreicht wird. In den weiteren Schaltungszweigen sind zu erkennen die Schalter S16, S15 und S13, die entsprechend während der Taktphase 6 bzw. 5 bzw. 3 geschlossen sind.

Abweichend von Fig. 4 ist in der Schaltung von Fig. 14 folgendes.

Der Schalter S15 ist nicht mit dem Schaltungsknoten 20 sondern mit dem Schaltungsknoten 25 verbunden. Weiterhin schliesst der im unteren Längszweig liegende Schalter S46 bei den Taktphasen 4 und 6. Darüberhinaus kommt ein Schalter S25 hinzu, der während der Taktphase 5 schliesst und in dieser Taktphase den Schaltungsknoten 20 mit Bezugspotential 18 verbindet.

Der Erfindung zugrunde liegende Untersuchungen haben nun gezeigt, dass an den Eingangsklemmen 17 und 21 entsprechend der Forderung gemäss dem Ersatzschaltbild von Fig. 13 dann die Ladung Q(z) = $Q_L(z)$ + $Q_C(z)$ aufgenommen wird, d.h. ein verlustfreier Parallelkreis simuliert wird, wenn die folgenden Beziehungen eingehalten werden:

$$C_0 = C + C_L, \quad C_1 = \frac{C_0^2}{3C_L-C}, \quad C_2 = \frac{C_0^2}{4C_L}, \quad C_L = \frac{T^2}{4_L}.$$

Um den Unterschied gegenüber der Bemessung nach Fig. 4 deutlich zu machen, sind in Fig. 14 die Kapazitätswerte der Kondensatoren 15 bzw. 16 bzw. 14 mit $C_0$ bzw. $C_1$ bzw. $C_2$ bezeichnet.

Mit der vorstehend beschriebenen Bemessung lassen sich Resonanzkreise realisieren, deren Resonanzfrequenz kleiner als F/6 ist, wobei in diesem Fall der Schalter S25 nicht benötigt wird und im übrigen die Schaltung gemäss Fig. 4 aufgebaut und betrieben wird.

Resonanzkreise, deren Resonanzfrequenz grösser als F/6 ist, können erreicht werden unter Zuhilfenahme des zur Tastphase 5 schliessenden Schalters S25, wodurch ein Umpolen des Kondensators 15 während der Taktphase 5 erreicht wird, so dass also in diesem Fall die Schaltung gemäss Fig. 14 aufgebaut ist und nach dem hierzu angegebenen Taktschema betrieben wird.

Die vorstehend beschriebenen Schaltungen haben also den Vorteil, dass praktisch ohne zusätzlichen Schaltungsaufwand aktive Schaltungen mit dem Charakter eines schwebenden Parallelresonanzkreises realisiert werden können, deren Parallelresonanzfrequenz entweder kleiner oder grösser als ein Sechstel der systemeigenen Taktfrequenz F ist.

**Patentansprüche**

1. Elektrische Filterschaltung unter Verwendung von wenigstens einer simulierten Induktivität, die nach vorgegebenen Taktphasen (Fig. 2) gesteuerte Schalter, Kondensatoren und Verstärker enthält und bei der ein Operationsverstärker (10) vorgesehen ist, zwischen dessen Ausgang (13) und invertierendem Eingang (11) ein Kondensator (14) liegt und dessen nicht invertierender Eingang (12) an einem festen Bezugspotential, insbesondere Massepotential (18) liegt, bei der weiterhin vom invertierenden Eingang (11) des Operationsverstärkers (10) ein Schalter (S13) zu einem ersten Schaltungsknoten (19) führt, von dem aus ein Kondensator (16) nach Massepotential (18) gelegt ist und ein weiterer Schalter (S14) zu einem zweiten Schaltungsknoten (20) führt, dadurch gekennzeichnet, dass von diesem zweiten Schaltungsknoten (20) aus ein Kondensator (15) nach Massepotential (18) liegt, dass vom zweiten Schaltungsknoten (20) ein Schalter (S15) zum invertierenden Eingang (11) und ein weiterer Schalter (S16) zum Ausgang (13) des Operationsverstärkers (10) führt und ein weiterer Schalter (S23) zur ersten Eingangsklemme (17) führt, und dass die Schalter S13 und S23 gleichzeitig während einer Taktphase 3 schliessen und in anschliessenden, zeitlich nicht überlappenden Taktphasen 4, 5, 6 die Schalter S14, S15 und S16 nacheinander geschlossen sind.

2. Filterschaltung nach Anspruch 1, dadurch gekennzeichnet, dass der Kapazitätswert des zwischen Ausgang (13) und invertierendem Eingang (11) des Operationsverstärkers (10) liegenden Kondensators (14) den vierten Teil (C/4) des Kapazitätswertes (C) des zwischen dem zweiten Schaltungsknoten (20) und Massepotential (18) liegenden Kondensators (15) und demgegenüber der zwischen dem ersten Schaltungsknoten (19) und Massepotential (18) liegende Kondensator (16) den dritten Teil C/3 von dessen Kapazitätswert C hat (Fig. 1, 2, 3).

3. Filterschaltung nach Anspruch 1 oder 2, dadurch gekennzeichnet, dass der vom zweiten Schaltungsknoten (20) ausgehende Kondensator (15) einerseits über einen Schalter (S33) mit der zweiten Eingangsklemme (21) und andererseits über einen Schalter (S456) mit Massepotential (18) verbunden ist und diese beiden Schalter (S33 und S456) entsprechend während der Taktphase 3 bzw. 4, 5 und 6 nacheinander geschlossen sind (Fig. 2, 4, 5).

4. Filterschaltung nach einem der vorhergehenden Ansprüche, dadurch gekennzeichnet, dass vom zweiten Schaltungsknoten (20) ein Schalter (S26) zu einem dritten Schaltungsknoten (23) führt, an dem einerseits auch der zur ersten Eingangsklemme (17) führende Schalter (S23) liegt, und andererseits ein zusätzlicher Kondensator (15') zu einem vierten Schaltungsknoten (22) führt, von dem aus einerseits ein Schalter (S43) zum zweiten Schaltungsknoten (20) und andererseits ein Schalter (S36) zur zweiten Eingangsklemme (21) führt, und dass die zusätzlichen Schalter (S43, S26 und S36) entsprechend während der Taktphase 3 bzw. 6 geschlossen sind (Fig. 2, 6, 4).

5. Filterschaltung nach Anspruch 4, dadurch gekennzeichnet, dass der zusätzliche Kondensator (15') den gleichen Kapazitätswert hat wie der über den Schalter S43 angeschaltete Kondensator (15) (Fig. 2, 6, 4).

6. Filterschaltung nach einem der vorhergehenden Ansprüche, dadurch gekennzeichnet, dass zur Realisierung einer allgemeinen Abzweigschaltung deren Kondensatoren als Kondensatoren ($C_1$, $C_2$, $C_3$) nachgebildet sind, und dass in äusseren Schaltkreisen über weitere Schalter (S11, S21, S31, S41 bzw. S12, S22, S32, S42) periodisch umgepolte Kondensatoren ($C_0$, $C_L$) zur Nachbildung der Widerstände eingeschaltet sind und dass die Schalter S11, S21, S31, S41 während der Taktphase 1 und die Schalter S12, S22, S32, S42 während der Taktphase 2 geschlossen sind (Fig. 2, 9, 10).

7. Filterschaltung nach einem der Ansprüche 3 bis 6, dadurch gekennzeichnet, dass von der zweiten Eingangsklemme (21) ein Spannungsverstärker (26) mit der Verstärkung (+1) über einen Schalter (S6') an einen Schaltungsknoten (25) angeschaltet ist, an den auch der Kondensator (15) angeschaltet ist, der zur Induktivitätsnachbildung den grössten Kapazitätswert aufweist, und dass der Schalter S6' während einer Taktphase 6' geschlossen ist, die unmittelbar zwischen den Taktphasen 6 und 3 auftritt (Fig. 2, 11).

8. Filterschaltung nach einem der vorhergehenden Ansprüche, dadurch gekennzeichnet, dass der den Generatorinnenwiderstand nachbildende periodisch umgepolte Kondensator ($C_0$) an einen sechsten Schaltungsknoten (30) angeschaltet ist, von dem einerseits ein Schalter (S53) zur Signalspannungsquelle ($U_0$) und andererseits ein Schalter (S46) an eine Ausgangsklemme (31) führt, und dass die Schalter S53 und S46 entsprechend in den Taktphasen 3 bzw. 6 geschlossen sind (Fig. 2, 12).

9. Filterschaltung nach einem der vorhergehenden Ansprüche, dadurch gekennzeichnet, dass die Kapazitätswerte $C_0$, $C_1$, $C_2$ für die in der Schaltung vorgesehenen Kondensatoren (15, 16, 14) nach folgender Beziehung bemessen sind:

$$C_0 = C + C_L, \quad C_1 = \frac{C_0^2}{3C_L \text{-} C}, \quad C_2 = \frac{C_0^2}{4C_L}, \quad C_L = \frac{T^2}{4_L}.$$

hierin bedeuten noch C bzw. L den Kapazitätswert für den zu realisierenden Parallelresonanzkreis (Fig. 13, 14).

10. Elektrische Filterschaltung nach Anspruch 9, dadurch gekennzeichnet, dass der nach Massepotential führende Kondensator ($C_0$) in der Weise umgepolt wird, dass die vom Schalter (S15) kommende Leitung anstelle zum zweiten Schaltungsknoten (20) zum weiteren Schaltungsknoten (25) führt, dass der dort (25) nachgeschaltete Schalter (S46) anstelle der Taktphasen 4, 5, 6 während der Taktphasen 4 und 6 geschlossen ist, und dass vom zweiten Schaltungs-knoten (20) ein weiterer, während der Taktphase 5 schliessender Schalter (S25) nach Bezugspotential (18) führt (Fig. 13, 14).

**Revendications**

1. Circuit de filtre électrique avec mise en oeuvre d'au moins une inductance simulée, qui contient des commutateurs, des condensateurs, des amplificateurs commandés selon des phases de cadence prédéterminées (figure 2), et dans lequel il est prévu un amplificateur opérationnel (10) entre la sortie (13) duquel et l'entrée inverseuse (11) duquel est branché un condensateur (14) et dont l'entrée non inverseuse (12) est portée à un potentiel de référence fixe, notamment le potentiel de la masse (18), dans lequel en outre un commutateur (S13) relie l'entrée inverseuse (11) de l'amplificateur opérationnel (10) à un premier noeud (19) du circuit, à partir duquel un condensateur (16) est porté au potentiel de la masse (18), et un autre commutateur (S14) est relié à un second point (20) du circuit, caractérisé en ce qu'un condensateur (15) est porté au potentiel de la masse (18) à partir de ce second noeud (20) du circuit, que le second noeud (20) du circuit est relié par un commutateur (S15) à l'entrée inverseuse (11) et par un autre commutateur (S16) à la sortie (13) de l'amplificateur opérationnel (10), et qu'un autre commutateur (S23) est relié à la première borne d'entrée (17), et que les commutateurs (S13 et S23) se ferment simultanément pendant une phase de cadence (3) et que les commutateurs (S14, S15 et S16) sont fermés successivement pendant des phases ultérieures de cadence (4, 5, 6) ne se chevauchant pas dans le temps.

2. Circuit de filtre selon la revendication 1, caractérisé en ce que la capacité du condensateur (14) situé entre la sortie (13) et l'entrée inverseuse (11) de l'amplificateur opérationnel (10) est égale au quart (C/4) de la capacité (C) du condensateur (15) situé entre le second noeud (20) du circuit et le potentiel de la masse (18) et qu'au contraire le condensateur (16) situé entre le premier noeud (19) du circuit et le potentiel de masse (18) est égal au tiers (C/3) de la capacité du condensateur (15) (figures 1, 2, 3).

3. Circuit de filtre selon la revendication 1 ou 2, caractérisé en ce que le condensateur (15) relié au second noeud (20) du circuit est raccordé d'une part par l'intermédiaire d'un commutateur (S33) à la seconde borne d'entrée (21) et d'autre part par l'intermédiaire d'un commutateur (S456) au potentiel de masse (18), et que ces deux commutateurs (S33 et S456) sont fermés successivement de façon correspondante pendant les phases de cadence (3 ou 4, 5 et 6) (figures 2, 4, 5).

4. Circuit de filtre selon l'une des revendications précédentes, caractérisé en ce que le second noeud (20) du circuit est relié par un commutateur (S26) à un troisième noeud (23) du circuit auquel d'une part est relié également le commutateur (S23) relié à la première borne d'entrée (17), et qui d'autre part est relié par un condensateur supplémentaire (15') à un quatrième noeud (22) du circuit, qui est raccordé d'une part par un commutateur (S43) au second noeud (20) du circuit et d'autre part par un commutateur (S36) à la seconde borne d'entrée (21), et que les commutateurs supplémentaires (S43, S26 et S36) sont raccordés de façon correspondante pendant les phases de cadence (3 ou 6) (figures 2, 6, 4).

5. Circuit de filtre selon la revendication 4, caractérisé en ce que le condensateur supplémentaire (15') possède la même capacité que le condensateur (15) raccordé par l'intermédiaire du commutateur (S43) (figures 2, 6, 4).

6. Circuit de filtre selon l'une des revendications précédentes, caractérisé en ce que pour réaliser un circuit général de dérivation, dont les condensateurs sont simulés par des condensateurs ($C_1$, $C_2$, $C_3$), et que des condensateurs ($C_0$, $C_L$), dont la polarité est inversée périodiquement et qui servent à simuler les résistances, sont branchés par l'intermédiaire d'autres commutateurs (S11, S21, S31, S41 ou S12, S22, S32, S42) dans des circuits extérieurs, et que les commutateurs (S11, S21, S31, S41) sont fermés pendant la phase de cadence (1) et les commutateurs (S12, S22, S32, S42) sont fermés pendant la phase de cadence (2) (figures 2, 9, 10).

7. Circuit de filtre selon l'une des revendications 3 à 6, caractérisé en ce qu'un amplificateur de tension (26) effectuant l'amplification (+1) est raccordé entre la seconde borne d'entrée (21) et un second noeud (25) du circuit par l'intermédiaire d'un commutateur (S6') auquel est raccordé également le condensateur (15) qui possède la capacité maximale pour la simulation de l'inductance, et que le commutateur (S6') est fermé pendant una phase de cadence (6') qui apparaît directement entre les phases de cadence (6 et 3) (figures 2, 11).

8. Circuit de filtre selon l'une des revendications précédentes, caractérisé en ce que le condensateur ($C_0$) qui simule la résistance interne du générateur et dont la polarité est inversée périodiquement, est raccordé à un sixième noeud (30) du circuit, qui est relié d'une part par le commutateur (S53) à la source de tension des signaux ($U_0$) et d'autre part par un commutateur (S46) à une borne de sortie (31), et que les commutateurs (S53 et S56) sont fermés de façon correspondante pendant les phases de cadence (3 et 6) (figures 2, 12).

9. Circuit de filtre selon l'une des revendications précédentes, caractérisé en ce que les capacités ($C_0$, $C_1$, $C_2$) des condensateurs (15, 16, 14) prévus dans le circuit sont dimensionnées selon les relations suivantes:

$$C_o = C + C_L, \quad C_1 = \frac{C_o^2}{3C_L\text{-}C}, \quad C_2 = \frac{C_o^2}{4C_L}, \quad C_L = \frac{T^2}{4_L}.$$

dans lesquelles C ou L désigne encore la capacité pour le circuit résonnant parallèle à réaliser (figure 13, figure 14).

10. Circuit de filtre électrique selon la revendication 9, caractérisé en ce que l'inversion de la polarité du condensateur ($C_0$), relié au potentiel de la masse, s'effectue grâce au fait que la ligne arrivant du commutateur (S15) aboutit non pas au noeud (20) du circuit, mais à lautre noeud (25) du circuit, que le commutateur (S46) branché en aval de ce noeud (25) est fermé non pas pendant les phases de cadence (4, 5, 6), mais pendant les phases de cadence (4 et 6), et qu'un autre commutateur (S25), qui se ferme pendant la phase de cadence (5), relie le second noeud (20) du circuit au potentiel de référence (18) (figures 13, 14).

**Claims**

1. An electrical filter circuit employing at least one simulated inductance formed by switches and capacitors controlling an amplifier in accordance with predetermined clock pulse phases (figure 2), and wherein an operational amplifier (10) is provided between whose output (13) and inverting input (11) there is arranged a capacitor (14), and whose noninverting input (12) is connected to a fixed reference potential, in particular earth potential (18), a switch (S13) leads from the inverting input (11) of the operational amplifier (10) to a first circuit node (19) from which a capacitor (16) is connected to earth potential (18) and a further switch (S14) leads to a second circuit node (20), characterised in that from this second circuit node (20) a capacitor (15) is connected to earth potential (18), a switch (S15) leads to the inverting input (11), a further switch (S16) leads to the output (13) of the operational amplifier (10), and a further switch (S23) leads to the first input terminal (17), and that the switches (S13 and S23) close simultaneously during a clock pulse phase (3) and in subsequent clock pulse phases (4, 5, 6) which do not overlap in time the switches (S14, S15 and S16) are closed consecutively.

2. A filter circuit as claimed in claim 1, characterised in that the capacitance value of the capacitor (14) located between output (13) and inverting input (11) of the operational amplifier (10) amounts to a quarter (C/4) of the capacitance value (C) of the capacitor (15) located between the second circuit node (20) and earth potential (18), whereas the capacitor (16) located between the first circuit node (19) and earth potential (18) has a third (C/3) of the capacitance value thereof (figures 1, 2, 3).

3. A filter circuit as claimed in claim 1 or 2, characterised in that the capacitor (15) is connected from the second circuit node (20) via a switch (S33) to the second input terminal (21), and via a switch (S456) to earth potential (18), and that these two switches (S33 and S456) are closed consecutively during the clock pulse phase (3 or 4, 5, 6 as the case may be) (figures 2, 4, 5).

4. A filter circuit as claimed in one of the preceding claims, characterised in that from the second circuit node (20) a switch (S26) leads to a third circuit node (23) at which the switch (S23) leading to the first input terminal (17) is connected and an additional capacitor (15') leads to a fourth circuit node (22) from which a switch (S43) leads to the second circuit node (20) and a switch (S36) leads to the second input terminal (21), and that the additional switches (S43, S26 and S36) are closed accordingly during the clock pulse phase (3 or 6) (figure 2, 6, 4).

5. A filter circuit as claimed in claim 4, characterised in that the additional capacitor (15') possesses the same capacitance value as the capacitor (15) which is connected via the switch (S43) (figures 2, 6, 4).

6. A filter circuit as claimed in one of the preceding claims, characterised in that an over-all branch circuit is formed with the capacitors thereof simulated (C₁, C₂, C₃), and that in external circuits via further switches (S11, S21, S31, S41 and S12, S22, S32, S42), capacitors (C₀, C_L) which are periodically reversed in polarity are connected in order to simulate resistors, and that the switches (S11, S21, S31, S41) are closed during clock pulse phase (1) whereas the switches (S12, S22, S32, S42) are closed during clock pulse phase (2) (figures 2, 9, 10).

7. A circuit arrangement as claimed in one of the claims 3 to 6, characterised in that from the second input terminal (21) a voltage amplifier (26) having the amplification (+1) is connected via a switch (S6') to a circuit node (25) to which is also connected the capacitor (15) which possesses the highest capacitance value for the inductance simulation, and that the switch (S6') is closed during a clock pulse phase (6') which occurs directly between the clock pulse phases 6 and 3 (figures 2, 11).

8. A filter circuit as claimed in one of the preceding claims, characterised in that the capacitor (C₀) which simulates the generator internal impedance and which is periodically reversed in polarity is connected to a sixth circuit node (30) from which a switch (S53) leads to the signal voltage source (U₀) and a switch (S46) leads to an output terminal (31), and that the switches (S53 and S46) are closed in respective clock pulse phases (3 and 6) (figures 2, 12).

9. A filter circuit as claimed in one of the preceding claims, characterised in that the capacitance values (C₀, C₁, C₂) for the capacitors (15, 16, 14) provided in the circuit are contrived in accordance with the following equations:

$$C_0 = C + C_L$$
$$C_1 = C_0^2/(3C_L-C)$$
$$C_2 = C_0^2/4C_L$$
$$C_L = T^2/4L$$

in which C or L is the capacitance value for the parallel resonant circuit which is to be constructed (figure 13, figure 14).

10. An electric filter circuit as claimed in claim 9, characterised in that the capacitor (C₀) which leads to earth potential is reversed in polarity in such manner that the line which emanates from the switch (S15) does not lead to the second circuit node (20) but to the further circuit node (25), that the switch (S46) connected following this point (25) is not closed during clock pulse phases (4, 5, 6) but during clock pulse phases (4 and 6), and that from the second circuit node (20) a further switch (S25) which closes during the clock pulse phase (5) leads to reference potential (18) (figures 13, 14).

# FIG 1

# FIG 2

# FIG 3

$$Z = sL = \psi R_C$$

$$R_C = \frac{T}{2C} \ , \ L = \frac{T^2}{4C}$$

# FIG 4

$$Z = sL = \psi R_C$$

# FIG 5

$$L = \frac{T^2}{4C}$$

$$R_C = \frac{T}{2C}$$

$$R' = \frac{T}{C'}$$

# FIG 6

# FIG 7

# FIG 8

# FIG 9

# FIG 10

# FIG 11

# FIG 12

## FIG **13**

$$L = \frac{T^2}{4C_L}$$

$Q_L(z)$

$Q_C(z)$

$C$

$Q(z)$

$U(z)$

## FIG **14**